# EUROPEAN PATENT APPLICATION

(11) **EP 4 730 187 A1**
(43) Date of publication of application: **22.04.2026**
(21) Application number: 24206999.5
(22) Date of filing: 16.10.2024
(51) Int. Cl.: G06F 30/27, G06F 30/3323

(54) **VERIFICATION TECHNIQUES USING LLM-BASED PROPERTY GENERATION**

(71) Applicant: Siemens Electronic Design Automation GmbH, 80634 München (DE)
(72) Inventor: Collazos Duran, Bryan Smith, 94032 Passau (DE); Jantsch, Simon, 80803 München (DE); Grosse, Joerg, 83727 Schliersee (DE); Brinkmann, Raik, 81371 Muenchen (DE)
(74) Representative: Siemens Patent Attorneys

(57) **Abstract**

A, preferably computer-implemented, method of verifying a design of an electronic circuit, comprising the steps of: prompting a large language model, LLM, with a design description in a machine-readable form, for example a hardware description language, HDL, for the LLM to provide one or more expressions specifying an intended functioning of the design in a natural language, prompting the same or another LLM with the one or more expressions for the LLM to provide one or more properties of the design in a machine-readable property description, for example a hardware verification language, HVL.

## Description

### TECHNICAL FIELD

The present disclosure relates to the design and/or verification of electronic circuits, and in particular integrated circuits, ICs. Integrated circuit design, semiconductor design, chip design or IC design, is a sub-field of electronics engineering, encompassing the particular logic and circuit design techniques required to design integrated circuits, or ICs. ICs consist of miniaturized electronic components built into an electrical network on a monolithic semiconductor substrate by photolithography.

IC design enables producing components such as microprocessors, FPGAs, memories (RAM, ROM, and flash) and/or digital ASICs.

In electronic design automation, EDA, software tools are used for designing electronic systems such as integrated circuits and printed circuit boards. The software tools work together in a design flow that chip designers use to design and analyze the chips. Since a modern semiconductor chip can have billions of components, EDA tools are essential for their design. A number of software tools are used to describe a circuit at various levels of granularity. Such tools include gate level descriptions, which specify the circuit in very great detail, to high level descriptions written in hardware description languages, HDLs, such as VERILOG or VHDL.

Independent of the grammatical term usage, individuals with male, female or other gender identities are included within the term.

### BACKGROUND

Design verification is the process of determining whether an integrated circuit, board, or system-level architecture, exactly implements the requirements defined by the specification of the architecture for that device. As designs become more complex, the likelihood of design errors increases and design verification becomes increasingly difficult and time consuming.

Presently, design verification may be performed using formal verification and/or a simulation model of the device. Formal verification is a mathematical and algorithmic solution designed to explore the entire state space of a design. Unlike simulation that tests the design functionality, formal verification proves that an implementation meets certain requirements. Therein, so called assertions, like for example assert, assume and/or restrict, be used to determine the analysis scope of the formal verification. A design's state space expands geometrically, cycle by cycle, starting from an initial state and examines all possible states. If illegal states are reachable, a bug is found. Otherwise, a proof of the intended functionality is obtained.

A conventional process of verifying a design through a simulation or formal verification of the design is aided by the availability of HDLs. During simulation, the simulated model of the design receives input stimuli in the form of test vectors, which may be a string of binary digits applied to the input of a circuit. The simulated model then produces results, which are checked against expected results for the particular design of the device.

Since HDLs are typically not designed for verification, a verification engineer must write additional code to interface with the designs described by these HDLs in order to perform design verification of the device. To that end, a hardware verification language, HVL, may be used. HVL may be understood as a specification language used to verify a design of electronic circuit written in a hardware description language. HVLs typically may include features of a high-level programming language like C++ or Java as well as features for easy bit-level manipulation similar to those found in HDLs. Many HVLs will provide constrained random stimulus generation, and functional coverage constructs to assist with complex hardware verification. SystemVerilog, OpenVera, e, and SystemC are the most commonly used HVLs. SystemVerilog attempts to combine HDL and HVL constructs into a single standard, i.e. IEEE Std 1800^{™}-2017.

The ability to analyze, test and validate hardware circuits and/or system-on-chips is crucial for the digital design process, since undetected errors incur severe risks with respect to security, safety and potential financial loss. One approach to prevent such errors is to create formal specifications of the properties one expects the design to satisfy, and to verify that they hold in the design. This method is commonly referred to as "formal verification". The most common languages used to express properties are "SystemVerilog Assertions", SVA, and the "Property specification language", PSL, both of which are standardized and used widely in industry. It should be understood that an HVLs may comprise an HDL, i.e. has an HDL built-in.

One of the major challenges when applying formal verification is creating the formal specification in a hardware verification language. The common specification languages are inherently complex temporal logics, thereby requiring specific expert knowledge from hardware designers which is not always readily available. Coming up with a set of properties which completely and accurately represents the intended properties of the circuit requires significant experience. This process is generally very time-consuming and error-prone, and this hinders the wide-spread application of formal verification and/or simulation.

### SUMMARY

It is thus desired to automatically generate properties which capture the intended functionality of a hardware circuit design preferably based on a design description.

According to a first aspect the object is achieved by a, preferably computer-implemented, method of verifying a design of an electronic circuit. The method comprising the step of prompting a large language model, LLM, with a design description in a machine-readable form, such as a hardware description language, HDL, for the LLM to provide one or more expressions specifying an intended functioning of the design in a natural language. The method further comprising prompting the same or another LLM with the one or more expressions for the LLM to provide one or more properties of the design in a machine-readable property description, for example a hardware verification language, HVL.

According to a second aspect a computer program is proposed. The computer program comprises program code that when executed performs the steps of first aspect.

According to a third aspect an apparatus, preferably comprising a processor and a memory, is proposed. The apparatus operative to perform the steps of the first aspect.

Large-language models, LLMs, offer a great potential for automatically capturing the intent and/or functionality of an electronic design, such as a hardware circuit designs and in particular an integrated circuit, IC. For the processing by the LLM the design description may be in a machine-readable form, for example may be provided in a hardware description language, HDL. However, using LLMs naively may result in syntactically or semantically incorrect specifications. According to the embodiments of the present disclosure the power of LLMs is leveraged in order to produce syntactically and/or semantically correct formal specifications in terms of properties. The one or more properties may be provided in the form of a machine-readable property description. Thereby, the one or more properties may be processed by a verification engine, e.g., a formal verification engine, in order to check whether the property is satisfied, i.e. holds. Furthermore, the present disclosure enables a user to make use of the generated expressions and/or properties in an effective manner.
- Figure 1: shows steps in the design flow of an integrated circuit.
- Figure 2: shows further details relating to the verification of a design during a design flow.
- Figure 3a: shows an illustration of an integrated circuit.
- Figure 3b: shows an exemplary design description in a hardware description language.
- Figure 4: shows exemplary steps for LLM-based property generation and IC design verification.
- Figure 5: shows another exemplary illustration of LLM-based property generation generation comprising an assertion generation loop.
- Figure 6: shows another exemplary illustration of LLM-based property generation comprising a testbench evaluation.
- Figure 7: shows another exemplary illustration of LLM-based property generation comprising further details of an assertion generation loop.
- Figure 8: shows another exemplary illustration of LLM-based property generation comprising coverage analysis and information, respectively.
- Figure 9: shows yet another exemplary illustration of LLM-based property generation comprising inter alia a ranking of properties.
- Figure 10: shows an illustration of a GUI of a software program for LLM-based property generation.
- Figure 11: shows an illustration of a GUI comprising selection of exemplary property types.
- Figure 12: shows an illustration of a GUI comprising an expression in natural language and a corresponding property.
- Figure 13: shows an illustration of a GUI comprising an editable property.
- Figure 14-22: show exemplary steps of LLM-based property verification.

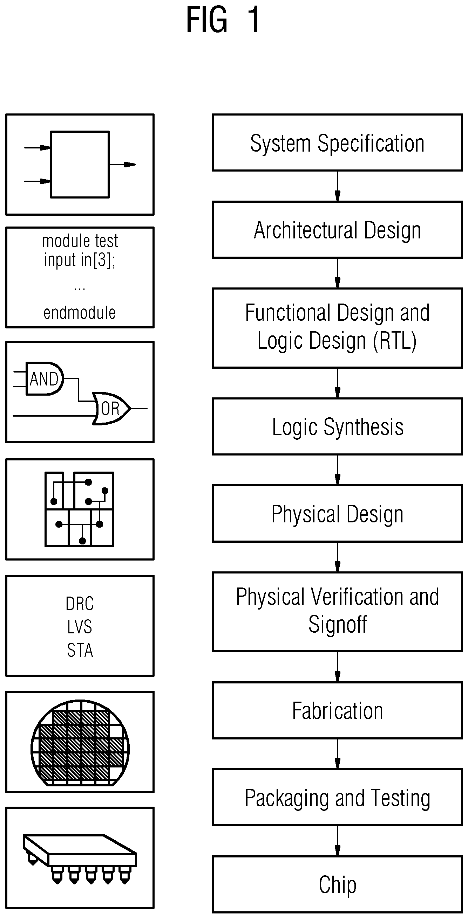

Figure 1 shows a plurality of exemplary steps in the design flow of an integrated circuit, IC. Exemplarily an IC is shown, however any other electronic circuit may have the same or a similar design flow. Hence, the terms integrated circuit, electronic circuit and hardware circuit are used interchangeably herein. A typical IC design flow involves several steps such as system specification. The system specification may comprise a feasibility study and/or a die size estimate, as well as a function analysis. Then the architectural or system-level design may be conceptualized. Furthermore, a (logic) design of the integrated circuit at the register transfer level may be created, e.g., in an HDL. As part of the (logic) design, an analogue design, a simulation, and/or a layout may be created. Furthermore, a digital design may be created, and simulation thereof may be performed. In an interim step, a simulation, emulation, and/or verification of the (logic) design using one or more EDA software tools may be performed. In a following step a circuit design may be created. The creation of the circuit design may comprise a synthesis of the (logic) design. It may further comprise a test design and automatic test pattern generation. The design may then be adapted for manufacturability and in a further step the physical design may be created. This may comprise floor planning, i.e. a schematic representation of tentative placement of the major functional blocks of the integrated circuit. Furthermore, during the place and route stage one or more schematics, HDL files, or pre-routed IP cores, or some combination of all three are automatically converted to a mask work in the standard GDS II or the OASIS format. During the parasitic extraction the parasitic effects, e.g., in both the designed devices and the required wiring are calculated. During the physical verification and signoff the integrated circuit layout design may be verified using one or more EDA software tools to ensure correct electrical and/or logical functionality and manufacturability. During this stage the static timing may be checked and co-simulation, e.g., of electro-magnetic effects may be performed. During the mask data preparation, also known as layout post processing, a file containing the intended set of polygons from an integrated circuit layout is translated into a set of instructions that a photomask writer can use to generate a physical mask. Typically, amendments and additions to the chip layout are performed in order to convert the physical layout into data for mask production. Finally, in the tape-out stage of the IC design process the photomask(s) are sent for manufacturing. The tape-out is specifically the point at which the graphic for the photomask of the circuit is sent to the fabrication facility for the integrated circuits, e.g. chips, to be produced.

Roughly saying, digital IC design can be divided into three parts. At first, electronic system-level design maybe performed. This step creates the user functional specification. The user may use a variety of languages and tools to create this description. Examples include a C/C++ model, VHDL, SystemC, Verilog, SystemVerilog, Transaction Level Models, Simulink, and MATLAB. Then, during the RTL design the user specification is converted into a register transfer level, RTL, description. The RTL describes the exact behavior of the digital circuits on the chip, as well as the interconnections to inputs and outputs. In the last step the physical circuit design is created. This step takes the RTL description, and a library of available logic gates, also referred to as standard cell library, and creates an IC design. This step may involve the use of an IC layout editor, layout and floor planning, figuring out which gates to use, defining places for them, and wiring (clock timing synthesis, routing) them together.

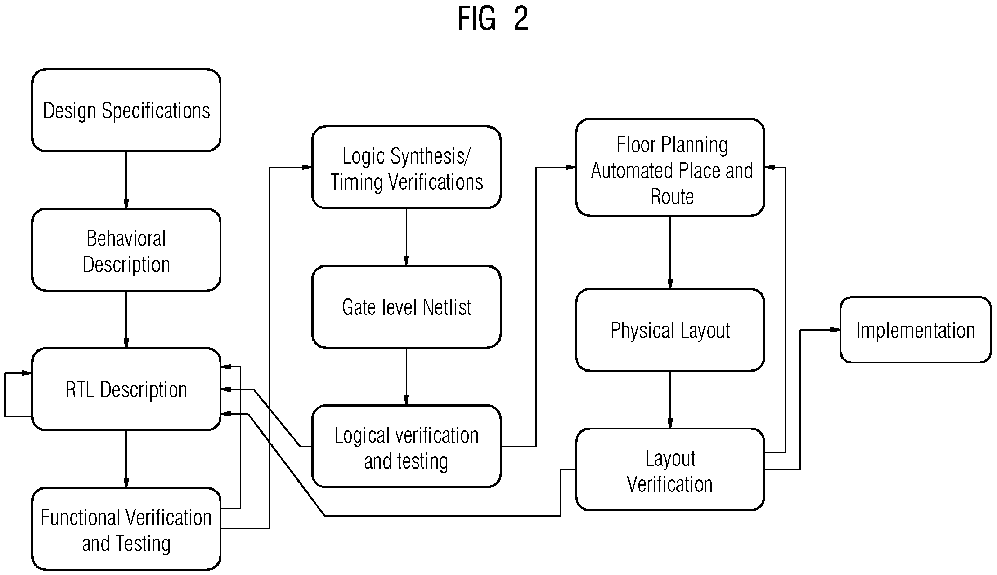

Figure 2 shows further details of a design flow. A hardware description language, HDL, such as Verilog may be used for designing and documenting digital systems such as integrated circuits. Verilog is extensively used in the design and verification of digital circuits at various abstraction levels, from the transistor level to the system level. The language describes digital systems - such as application-specific integrated circuits (ASICs) and field-programmable gate arrays, FPGAs - and supports various descriptions, including behavioral, register transfer level, and gate-level representations. A hardware description language, HDL, describes how hardware components are interconnected and/or how a complete circuit should behave, i.e., function.

Similarly, as before in Figure 1, the specification of the IC is created at first and describes the functionality, interface, and/or architecture of the digital IC circuit to be designed. Subsequently, a behavioral description is created to analyze the design in terms of its functionality, performance, compliance with given standards, and/or other specifications. Once the RTL description is in place, one or more Electronic Design Automation, EDA, tools are typically used to take an IC design to the next stage. These tools are instrumental in verifying the design's functionality, ensuring a reliable design process. The RTL description is converted to a gate-level netlist using logic synthesis tools. A gate-level netlist describes the circuit in terms of the gates and connections between them, which are made to meet the timing, power, and area specifications. The IC design may once again be logically verified and tested. If any problems are found, it's necessary to restart the process from the RTL description, or even the design specification and/or the behavioral description. Once the design is deemed flawless, the floor planning may be performed. Here, every component is strategically placed, including its' routes and interconnections, ensuring the structural integrity of the circuit. Lastly, a physical layout is created, which will be verified and then sent to fabrication.

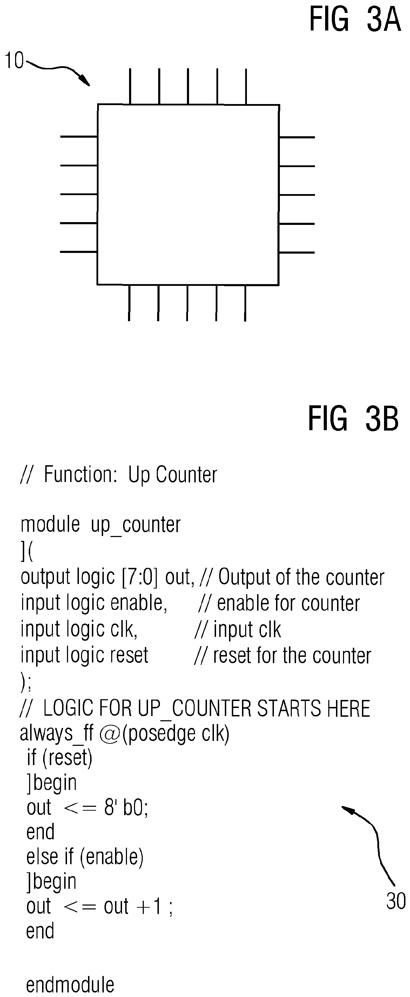

Figure 3a shows an illustration of an electronic circuit 10, such as an integrated circuit. The use of complex integrated circuits, ICs, in particular in safety-critical systems is now commonplace throughout many industry sectors, including automotive, aerospace, power generation, defense, and medical devices. Governed by a range of regulatory standards, the development of these systems must be proven to be rigorous and/or compliant to a set of requirements. Moreover, to improve the safe operation of these systems, safety mechanisms or redundancy are integrated that ensure a reliable, deterministic reaction to random hardware faults when the device is operating in the field. In particular the automotive market, governed by the ISO 26262 standard, demands a particularly rigorous development methodology. This includes requirements tracing from specification to verification and coverage, analysis of failure modes, and risk assessment and/or mitigation techniques.

An integrated circuit, IC, 10 also referred to as a chip, or a microchip is a set of electronic circuits on a piece of semi-conductor material, usually silicon. Large numbers of miniaturized transistors and other electronic components that per-form logic operations and are referred to as logic elements are integrated together on the chip. An integrated circuit or an IC is a semiconductor hardware on which electric circuits are mounted. An integrated circuit and/or an IC design can thus be considered as a hardware (design).

Integrated circuits are composed of multiple interconnected logic elements such as logic gates, flip-flops, and registers. These logic elements interact with each other to perform a specific function. Formal verification is a method for verifying the correctness of an IC design using mathematical techniques. Verification is the process of verifying that a system, such as an IC, or component meets its functional requirements. This includes verifying that the system behaves as intended and that it meets the specifications.

During formal verification, a model, also referred to as design, of the IC is created in a hardware description language, HDL, that specifies the desired behavior of the IC using a set of logical properties or assertions. The model is then checked against the properties to ensure that the IC behaves as expected. Hence, a method of verifying an electronic circuit, such as an integrated circuit, is proposed herein. Since the electronic circuit may be represented by a design and a corresponding design description the method may comprise verifying a design of an electronic circuit. The electronic circuit and in particular the integrated circuit may thus be represented by a design. The design and/or a design description may be given in a machine-readable form. The design description may thus correspond to or represent the design.

When verifying a system, one needs to analyze all possible states and transitions to ensure that the system behaves as expected. However, as the number of components, variables, and possible interactions between them increases, the number of possible states grows exponentially, making it impractical or even impossible to verify the system exhaustively.

In formal verification, the state explosion problem refers to the exponential growth in the number of states that need to be examined as the size and complexity of a system being verified increases. The state explosion problem arises because the number of possible states of an IC increases exponentially with the number of logic elements and/or the number of inputs. The state explosion problem poses a significant challenge in for-mal verification, and various techniques have been developed to address it. Some of these techniques include abstraction, model checking, and theorem proving. These approaches allow verification engineers to reason about the system's behavior using simplified models or by analyzing specific properties of the system. However, even with these techniques, the state explosion problem remains a significant challenge in formal verification.

In electronic design, e.g., for integrated circuits, a Hardware Description Language, HDL, may be used, e.g., at the register transfer level, RTL. Figure 3b shows an exemplary design description in a machine-readable form. In this case the design description is provided in a hardware description language, HDL. Therein, an 8-bit (up) counter is described in a hardware description language, in this case SystemVerilog. SystemVerilog, standardized as IEEE 1800, is a hardware description and hardware verification language used to model, design, simulate, test and implement electronic systems. SystemVerilog is based on Verilog and some extensions, and since 2008, Verilog is now part of the same IEEE standard. It is commonly used in the semiconductor and electronic design industry as an evolution of Verilog. The design description may be stored in a (SystemVerilog) file, which may be stored on a (non-volatile) memory. The design description may be written in a text editor, such as an HDL editor. An HVL may encompass, extend, and/or comprise an HDL, like in the case of Verilog and SystemVerilog. Hence, an HVL specification language is designed to coexist and/or enhance a hardware description language. An HVL, like SystemVerilog, enables the use of a unified language for abstract and detailed specification of the design, specification of assertions, coverage, and/or testbench verification based on manual or automatic methodologies. In any case a machine-readable property description may be used to describe the properties of the design (description).

A machine-readable property description, such as HVL may offer statements, in the form of assertions, that specify the verification function to be performed on an underlying property. An assertion statement, or assertion for short, may for example be "assert", which is used to specify the property as an obligation for the design that is to be checked to verify that the property holds, or "assume", which is used to specify the property as an assumption for the environment. In the case of an "assume", a simulator may check that the property holds, while formal tools, i.e. a verification engine, may the information to generate input stimulus. "Cover" is used to monitor the property evaluation for coverage. "Restrict" is used to specify the property as a constraint on formal verification computations. Simulators may not check the property if "restrict" is used.

For example, a machine-readable property description and HVL like SystemVerilog makes use of assertions that are built from sequences and properties. Properties may be understood as a set of sequences, i.e. a sequence may be used as if it were a property. Sequences may comprise boolean expressions optionally augmented with temporal operators. An assertion may continually attempt to evaluate a sequence or property, e.g. with respect to the design (description). An assertion may then fail if the property fails.

Hence, a property describes the behavioral criterion that is evaluated by the assertion statement. The property may be an immediate condition, e.g., that the read_enable and write_enable signals are mutually exclusive, or it may be a temporal condition, e.g., that if a read_request occurs, then a read_grant occurs within two clock cycles. An assertion statement is either immediate, for which the underlying property must be an immediate condition, or concurrent, for which the underlying property may be either an immediate or a temporal condition. There is no immediate restrict assertion statement. Assertion statements can generate automatic messages to report that the disposition of the evaluation of the underlying property is of interest for the kind of the assertion statement, e.g., a failing evaluation disposition for an assert or assume, or a passing disposition for a cover. As mentioned herein, a design description can be in SystemVerilog which itself is a hardware description and verification languages, HVDL.

Now, when creating a design description in HDL code, a lot of errors can happen. These can be simple typos, syntax errors, semantic errors and/or structural errors. To verify the function of a design, i.e. a hardware model, e.g., in VHDL or Verilog, it is necessary to check how the design behaves in the context of the system. This can be achieved, for example, by modelling the behavior with so-called properties, or by stimulating the HDL code. For this stimulation, one usually uses a testbench that reproduces the behavior of the system.

The formal verification approach uses specification languages based on temporal logic to define properties that make assertions about the expected system behavior. A verification procedure then verifies if the system is designed according to the specification. Nevertheless, the properties definition is not a trivial task. It depends on verification engineers skills to understand the specification and their expertise in temporal logic. This generally increases the project cost and time, and turns it more susceptible to human error.

Properties may be expressed in the form of assertions and/or may be verified using assertion-based verification tools, also referred to as verification engine(s). Properties may be classified into two main classes: safety and liveness. Safety properties state that something bad never happens or that something good always happens. Liveness properties assert that something eventually or repeatedly happens. Properties, i.e., assertions, thus allow definitions about the behavior of a design and may be used in both simulation-based and formal verification. The most commonly used approach to verify HDL designs are based on both simulation and formal verification. The HDL may be verified by simulation, e.g. using testbenches, or by model checking. When no more inconsistencies are found, e.g. all assertions and/or properties are satisfied, the HDL model is synthesized.

Considering a model checker as a verification engine, the implementation is automatically converted into a formal model, and may be verified against the specifications. The system is checked if the set of properties defined from the specification are satisfied. Otherwise, if they are not satisfied, a counterexample is generated. A counterexample is an execution snapshot when a property is violated.

Verification techniques, and in particular formal property verification, FPV, may be used for verification of the design, in particular for finding bugs in the RTL description. However, formal properties, such as those written as SystemVerilog Assertions, SVA, are time-consuming and error-prone to write, even for experienced users. Hence, not only the design description but also the one or more properties, which, e.g., may be represented by temporal logic expressions, are susceptible to human errors, thus increasing the costs and time of the verification.

The design (description) may also be verified, e.g., by creating a testbench, in a verification engine, also referred to verification tool, such as ModelSim, that simulates behavioral, RTL and gate-level code. In general, a verification tool for simulation of hardware description languages may be used, e.g. in addition, or as alternative, to a formal verification method.

From "Using LLMs to Facilitate Formal Verification of RTL" by Orenes-Vera et al. (https://arxiv.org/abs/2309.09437) it has become known to use large language models, LLMs, to generate a formal specification in terms of a set of SVA properties for register transfer level, RTL, designs given as Verilog modules. Therein a method to interactively refine the prompt provided to the LLM is proposed. The idea is to start with a basic initial prompt, querying the result of the LLM for an example Verilog file, letting a human expert user analyze the errors of the produced properties, and extending the prompt by instructing the LLM to avoid the observed error. This is repeated until the LLM produces correct properties. Once a satisfactory initial prompt is found, it is used as the basis for the main algorithm, in particular, the proposed procedure to generate specifications does not include a feedback loop. Orenes-Vera et al. claim that the prompt produced in this manner generalizes well to other Verilog files.

Furthermore, the publication "AssertLLM: Generating and Evaluating Hardware Verification Assertions from Design Specifications via Multi-LLMs", https://arxiv.org/abs/2402.00386, Xie et al. is focused on translating natural language specifications into SystemVerilog assertions. Therein multiple LLMs are used to handle different tasks. One LLM is used to extract the required design assertions from the English language description of the design specification. Another LLM to extract the signal names involved in the RTL design and align them with the specifications, and a third LLM to generate SystemVerilog Assertions. They compare between GPT-3.5, and GPT-4.0 models, and use custom instructions, with no fine-tuning and no use of open source LLMs. While it's a new idea to use different LLMs in handling different activities, it's expected to be a big overhead during productization to manage and host three LLMs serving one product feature.

Hahn et al. focused on the general problem of generating formal languages like regular expressions, first order logic and linear temporal logic from formal specifications. Linear temporal logic is the basis of formal verification languages like SystemVerilog Assertion. In their "Formal Specifications from Natural Language" work, https://arxiv.org/abs/2206.01962, they generally proved that off-the-shelve LLMs can be fine-tuned to produce better syntax and semantically correct formal language from natural language descriptions. They used/developed specialized natural language description to notation-based formal language datasets to train the open source T5 Raffel model.

Nandal et al. compiled a useful testbench to evaluate different commercial and open source LLM models according to their work "AssertionBench: A Benchmark to Evaluate Large-Language Models for Assertion Generation" in https://arxiv.org/abs/2406.18627. The testbench is compiled from OpenCore designs, with verified assertions for designs like arbiter, UART, FPU, etc. Nandal et al. propose a 1-shot and 5-shot in-context examples to the LLM to help it produce correct assertions. Those few-shot examples are composed of design and verified assertions tuples. Nandal et al. propose correcting the generated assertions using another GPT-3.5 LLM and verifying the assertions using JasperGold Formal verification tool.

However, the problems mentioned herein with respect to the correctness and/or validity of the generated properties persist.

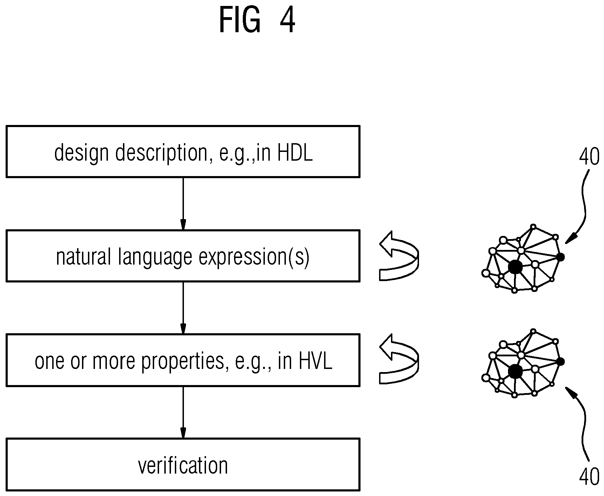

Turning to Figure 4, exemplary steps for LLM-based property generation and/or design verification are illustrated. It is thus an object to generate one or more properties, or more specifically one or more assertions, i.e. comprising the one or more properties, and specifically SystemVerilog assertions, e.g., according to the IEEE standard "1800-2017 - IEEE Standard for SystemVerilog".

It is proposed to automatically generate one or more properties which capture the intended functionality of a (hardware circuit) design, e.g., based on a Verilog file describing the design, and/or a natural language specification, e.g., provided by the user. The design description describing the electronic circuit or hardware circuit may be provided in an HDL, such as Verilog. It is proposed to use one or more large-language models, LLMs, to that end. The LLM may be prompted with the design description, e.g., in HDL. In general, the design description may be provided in a machine-readable form. The design description may thus be processed by the LLM. For example, the design description may be converted or compressed. The LLM may provide one or more natural language expressions as a result. The one or more natural language expressions describing the intended functioning or the one or more functionalities of the design or one or more parts of the design. LLMs offer great potential for automatically capturing the intent and/or functionality of a (hardware circuit) design, e.g., provided in a hardware description language such as Verilog. For example, Large Language Model Meta Al, i.e. LLaMA, for example in V3.0, or V3.1, or ChatGPT may be used as an LLM for generating the one or more natural language expressions and/or the properties, e.g., in HVL. In general, the properties may be provided in a machine-readable property description. A verification engine may then process the properties. For example, the verification engine may perform one or more verification tasks, and may for example check whether the one or more properties are satisfied. However, using LLMs naively may result in syntactically and/or semantically incorrect specifications. It is thus a further object to leverage the power of LLMs to produce syntactically and/or semantically correct formal specifications in terms of properties, or assertions, and/or to expose this functionality to a user, such as a hardware designer, in an effective way.

The LLM may be a foundational LLM and may, as the case may be, finetuned based on stored, known, and/or past verification test data, such as data relating to design verification testing, DVT. For example, already known properties and corresponding designs stored in a database may be used to (re-)train an (foundational) LLM. As a result, a finetuned LLM may be obtained. The LLM may be (re-)trained on a training server, e.g., using a training application. The finetuned LLM may then be deployed on an inference server. To that end, the (finetuned) LLM may be containerized and a container comprising the (finetuned) LLM may be deployed on the inference server.

Hence, by inputting a design description, e.g., a file (or a fragment thereof), in an machine-readable form, such as a HDL or comprising HDL code, into an LLM one or more expressions in a natural language, which for example are meant to hold true in the design, may be generated by the LLM. These expressions thus correspond to the intended, or correct functioning of the design. This is based on the ability of the LLM to recognize the intended functioning or functionality of the design (description), e.g., on the register transfer level. A (special) prompt may be used to instruct the LLM to determine the functionality of the design (description), e.g., in the form of the code, as one or more expression, preferably in a natural language, such as English, German, or the like. For example, the LLM may be prompted to summarize the design description or to summarize one or more functionalities or to summarize one or more parts (of the HDL code) of the design description. The design description, e.g. said code, for example in an HDL, may be included in the prompt. The step of generating the one or more natural language expressions can be performed repeatedly, e.g., until a predetermined number of expressions for a functionality are obtained. To that end, the LLM may be prompted repeatedly or may be instructed, e.g., prompted, to generate said predetermined number of expressions for said function or functionality, or for each one of the one or more functions or functionalities. It should be understood, that the machine-readable form of the design description may be derived from a design description, e.g., in HDL. For example, a compressed or converted form of the design description, e.g., in HDL, may be used.

It should be noted that an LLM may not be able to faithfully reproduce the exact functioning of a (hardware circuit) design in general, and that use is made of this effect. However, the LLM is able to identify the intended functioning or functionality, and thus may produce a description, e.g., in natural language, (using one or more natural language expressions) of the functionality (but not of its specific implementation) and of the intended (and thus correct) functioning. For example, consider an RTL design which "looks like a FIFO", but contains a difficult-to-spot mistake. Then, the LLM may well produce one or more properties for a correctly implemented FIFO, thereby enabling the error in the design to be uncovered. Thus, the LLM is capable of identifying the intended, or desired, or correct functioning of the design, or of a part of the design. To that end, the design description of the design may be used.

Generating one or more (or a set of) natural language expressions as a first step has several advantages over directly trying to generate one or more properties (or assertions) in a hardware verification language, e.g., HVL, e.g., SVA. At first, it gives the user a description of the property in a natural language, i.e. said one or more expressions, which a user can readily understand. Based on this, a user can examine and/or decide whether an expression makes sense, and, if yes, whether the generated property, e.g., in the form of an (SVA) assertion, matches the expression. A user may also be able to adapt the natural language expression (of an intended function/functioning), e.g., for further, or additional queries or prompts of the LLM. At second, by first generating one or more natural language expressions, the (subsequent) generation of the one or more properties, e.g. as an assertion or SVA specification, may be based on a subset, e.g. a single, of the expressions in the natural language, i.e. based on a single expression. This reduces the context the LLM obtains and let's the LLM focus on the prompted task, which leads to better properties, i.e., better generation of SVA assertions.

Furthermore, is proposed to repeatedly perform the step of generating one or more properties, or assertions. For example, an LLM, e.g., the same as before for generating the natural language expression, may be used for generating the one more properties, or assertions. The LLM can be instructed, e.g., prompted to repeatedly generate said one or more properties, e.g., until a predetermined number of properties are obtained. To that end, the LLM may be prompted repeatedly or may be instructed, e.g., prompted, to generate said predetermined number or plurality of properties for said one or more expressions or functionalities, or for each one of the one or more expressions or functionalities. As a result, a plurality of properties may be obtained. For a plurality or group of properties a representative property can be determined. It should be understood, that, as already mentioned, a property or an assertion comprising the property may be generated by the LLM. Hence, apart from cases where explicitly mentioned the terms property and assertion are used interchangeably. Furthermore, the terms function, functioning, and functionality, where function relates to an action that shall be performed by the design (or part thereof), functioning refers to the design (or part thereof) having a function, and functionality refers to the capability of the design (or part thereof) and are used interchangeably.

The property and/or one or more the properties may then be input in a verification engine, e.g., in order to check whether the one or more properties hold true. Hence, in general, a machine-readable property description may be used to make the properties accessible for the verification engine. Thus, a verification based on the one or more properties can be performed. In case a group of similar properties have been generated by the LLM a representative property from the group of properties may be used for verification. As described herein, a (string) similarity measure may be used to determine and/or group similar properties.

For example, based on the result of the verification, the design may be amended, e.g., edited, in order to remedy an error in the design. A result of the verification may be hold or fail, i.e. signifying the one or more properties are satisfied or not by the design. Subsequently, the verification process, e.g., as shown in Figure 4 can restart. If the one or more properties are satisfied or fulfilled the design can enter the next stage of the production process of the electronic circuit, e.g., may be synthesized. Hence, if the one or more properties of the design are fulfilled or satisfied the electronic circuit can be produced based on design.

Hence, as shown in Figure 4 the LLM may be repeatedly prompted for producing the one or more natural language expressions. Instead, or additionally, the LLM may be repeatedly prompted for producing the one or more properties. As a result, a plurality of natural language expressions and/or properties may be obtained for the same design. Alternatively, the one or more LLMs may be prompted to execute the steps of generating one or more natural language expressions and one or more properties altogether. For example, a single prompt instructing the LLM to perform said steps may be used.

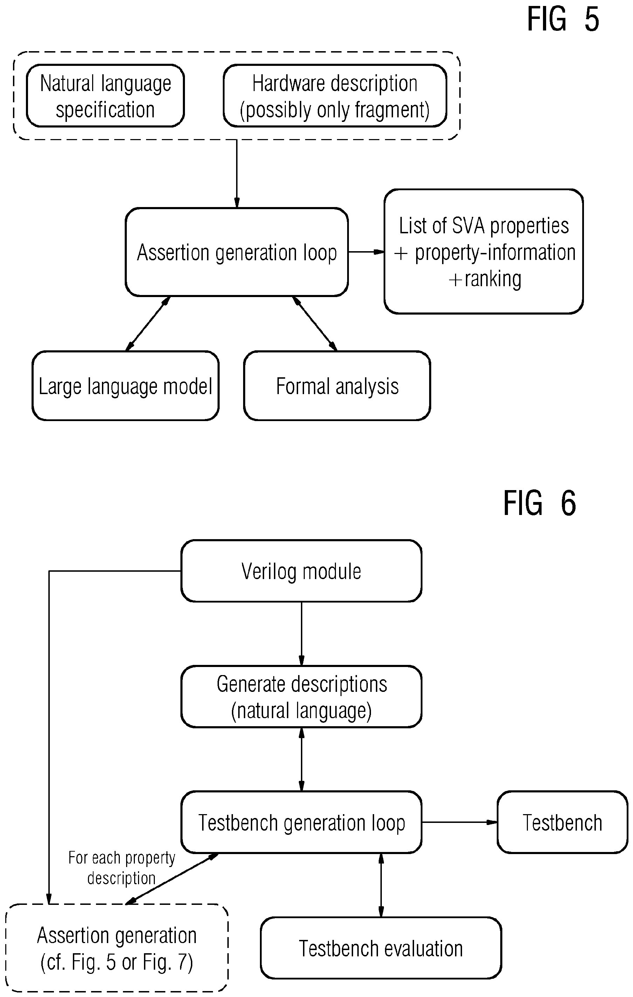

Now turning to Figure 5, the generation of one or more properties in HVL, e.g., as one or more assertions or as part of one or more assertions, is illustrated. It should be understood that the reference to HVL is exemplary and that in general a machine-readable property description can be used. Hence, HVL is used interchangeably with machine-readable property description. Two or more modes, i.e. mode A and/or mode B, are possible, both of which are implemented using a feedback-loop employing both an LLM and a verification engine, such as a formal verification tool, referred to as formal analysis in Figure 5.

In a first mode, a natural language specification of the design and a description of a design in a HDL, e.g., in the form of a Verilog code, representing a (fragment of) a hardware circuit, may be used. It should be understood that the reference to HDL is exemplary and that in general the design may be provided in a machine-readable form. Hence, HDL is used interchangeably with machine-readable form. The natural language specification may relate to the functioning of the design. That is, the natural language specification shall relate to one or more functions or one or more functionalities of the design - or part thereof. Hence, the natural language specification shall describe an intended functioning of the design. Basically, the natural language specification shall describe a desired or intended behavior of the design. This natural language specification may be provided by a user. For example, the natural language specification and the description of the design may be input into a software module or a software component. The software component or module may comprise or may interface with one or more LLMs, a verification engine, such as a formal analysis tool. The software component or module may serve for generating one or more properties, e.g. in the form of one or more assertions, in HVL and is denoted as "assertion generation loop" in Figure 5.

In the first mode A, the software component or module first generates for a given input, a prompt for the LLM. The prompt may include both, the natural language specification and the design description in HDL, e.g., said Verilog code. The result of the prompt, as output by the LLM, is evaluated by the software component, and if possible, one or more properties in HVL are extracted. The one or more properties may be passed to a verification engine, e.g., comprising a formal analysis tool. The formal analysis tool may serve for checking whether the one or more properties are syntactically correct, e.g., in relation to and/or in the context of the design (description). If not, an error message may be produced, which may then be used for creating one or more further prompts, e.g. by adapting the one or more prompts used, in order to inform the LLM why the syntax-check failed. To that end, the LLM may be provided with the result of the check of the formal analysis tool. However, the software component (or module), and/or the verification engine, in particular the formal analysis tool, may be configured to skip the syntax check.

In an assertion generation loop, e.g. of the software component or module, a plurality of properties for the same prompt or query may be generated, for example even if a syntactically correct property has already been found further properties may be generated. For example, the same query or prompt comprising the natural language specification and/or design description in HDL, or comprising the one or more expressions may be (repeatedly) input into the LLM. The statistical nature of the LLM then leads to a plurality of different results, i.e. differently formulated properties. As mentioned herein the one or more properties represent the intended and/or correct functioning of the design, for example of a function or functionality of the design, or of a part of the electronic/hardware circuit which is represented by the design. That is, for each query or prompt a different result will be obtained. As mentioned herein, the one or more LLMs may be instructed using a single prompt, e.g., for generating said plurality of differently formulated properties. The generated properties or a subset of the generated properties may be presented to a user. Additional information or data may be provided for each property, e.g., from the formal analysis tool. For example, the formal analysis tool may output whether the property is satisfied or not. The formal analysis tool may output the length of any given witness of the property or counterexample to the property, and/or a complexity-measure for the property. The complexity-measure may indicate how difficult the property is for the verification engine to check. The one or more results of the formal analysis tool may be used for prompting the LLM in order for the LLM to generate new one or more properties. Thereby, one or more adapted or improved properties can be obtained. These steps can be repeated until one or more adapted or improved properties are generated by the LLM that are satisfied by the design. Alternatively, or additionally, the design, e.g. in the HDL, may be adapted to satisfy the one or more properties, e.g. in the form of one or more assertions. One or more results of the LLM which cannot be parsed into a property (based on certain basic syntactic criteria) may be discarded by the formal analysis tool.

Once the one or more properties are generated, for example by the assertion generation loop, e.g., in the form of a group or list, the properties may be ranked. The ranking may comprise comparing each property with the one or more previous properties from the group or list. The comparison algorithm may be based on a string-similarity measure, e.g., a Levenshtein distance. The comparison algorithm may serve for computing a (decimal) value between 0 and 1 for each pair of assertions, i.e. properties in HVL. If this value exceeds a certain threshold, a counter for the property may be increased. In that case it is not necessary to check both of the properties, but it is sufficient to have one of them checked by the verification engine. Thereby, equivalent properties, e.g. from a plurality of properties, e.g. a group or list of properties, whose string-representation is not identical, but, e.g., similar or very close, for example based on a threshold comparison, can be identified. Then, only one representative property from said plurality of properties may be used for the verification. Typical differences between the different properties' textual representation in HVL that this procedure catches are, for example, extra spaces or parentheses. It should be understood that the plurality of properties may represent the same function, functioning or functionality in the design. Some of these properties may be similar enough to only consider a representative property, whereas one or more other properties may describe another aspect of the characteristic behavior of the intended functioning of the design (or part thereof) and may not be similar enough. Thus, the plurality of groups may represent different properties of the same function, functioning, or functionality of the design. As mentioned, a representative property of each group may be determined. However, it should also be understood, that a plurality of groups may be created, wherein each group represents a different function, functioning or functionality of the design.

The ranking of the (groups of) properties, or of the representative properties, may thus be determined based on the counter values of the properties in the resulting list. Therein the counter or counter value indicates the number of properties that are considered sufficiently similar to each other. For example, if the counter value is high, this indicates that the property (or similar ones) was often produced by the LLM, which indicates a higher probability, that, e.g., the property matches the natural language specification, or is a sensitive property after all, i.e. represents the intended function, functioning or functionality of the design (or part thereof).

Furthermore, it is possible to make use of a formal analysis, e.g. by said formal analysis tool, to rank properties, e.g., in addition or instead to the ranking based on string similarity. For example, in case different (representative) properties, e.g., groups of properties with the same counter value, a property whose verification result is "proven" or "true" (i.e. it is satisfied in the design of the hardware module) is preferred over one that "fails". Furthermore, properties which are rejected by the formal analysis tool because they could not be parsed, or they do not match the design of the hardware circuit, are ranked worst. This analysis step may be performed when the provided design description is a complete description of the hardware circuit, which e.g., can be analyzed by a formal verification engine, such as said formal analysis tool.

In this mode of operation, i.e. mode A, both, "assertions", which are properties, e.g., in SVA, meant to hold in the design, and "cover points", which are properties, e.g., in SVA, describing a behavior the user would like to observe in the design can be generated. The main difference between these properties is the type of trace a formal verification engine to generates. For assertions, counterexamples should be generated if the assertion does not hold. For cover points, traces which contain the behavior expressed by the cover point should be generated. The desired or intended behavior is expressed by the natural language specification. The natural language specification can be input together with the design description as part of a prompt for an LLM. The prompt may be generated by a software component or software module, e.g. interfacing with the LLM and/or the verification engine, e.g. said formal verification tool.

In Figure 6 a second mode, mode B, is illustrated. In the second mode (solely) a design description in HDL, e.g., a Verilog module, preferably without a natural language specification, may be prompted or input into the LLM. It should be understood that the reference to HDL is exemplary and that in general the design may be provided in a machine-readable form. Hence, HDL is used interchangeably with machine-readable form herein. Otherwise, the same description as in relation to in Figure 5 applies. A Verilog module is a block of a Verilog code that implements a certain functionality. Hence, a Verilog module represents a design that implements certain behavioral characteristics which will be converted into a digital circuit during synthesis. A set of expressions in natural language, which for example are supposed to hold true, i.e. be satisfied by, in the given design, i.e. design description, may be generated based on prompting an LLM with the design description in HDL. The LLM is instructed or queried by the prompt to generate one or more natural language expressions specifying an intended functioning of the design. Alternatively, or additionally, as e.g., described in relation to mode A, a user may provide one or more (additional) expressions in natural language, e.g., by inputting in a text editor or a graphical user interface. These one or more natural language expressions may be passed, e.g., altogether or one-by-one, to an assertion generation loop. Hence, the one or more natural language expressions are input into the same or a different LLM or the same or a different LLM (as used before to generate the one or more natural language expressions) is queried based on a prompt for the LLM to generate one or more properties in an HVL. The set of natural language expressions together with the corresponding properties, e.g., in SVA and/or as generated by the assertion generation loop, may form a testbench. It should be understood that the reference to HVL is exemplary and that in general a machine-readable property description can be used. Hence, HVL is used interchangeably with machine-readable property description herein.

Thus, a design may offer or intend to fulfill a certain function, functioning or may comprise one or more functionalities. In principle, a intended functioning or functionality may be implemented in a plurality of different manners - still fulfilling the functionality. The LLM is capable of determining the functionality, e.g., determine a name of or other identifier for that functionality, for example based on a declaration of the function, and in particular without understanding whether the implementation of the function is correct or not. The one or more functionalities may correspond to a functional requirement that may contain a unique name and number, a brief summary, and a rationale. This information may enable understanding why the requirement is needed, and to track the requirement through the development of the design and/or the during the verification. Based on the determined functioning or functionalities the LLM may provide the requirements as one or more natural language expressions.

To increase the quality of produced testbenches, a feedback loop, i.e. testbench generation loop as shown in Figure 6, based on a formal analysis of the testbench, i.e. a testbench evaluation, may be provided. The testbench evaluation may also be implemented in software, i.e. program code, as a software component or software module. The testbench evaluation may be based on computing a coverage measure from a subset of properties, e.g., which hold true in the given Verilog module. The coverage measure determines how much of the code is required to prove the one or more properties in a testbench. Uncovered code indicates that a certain functionality of the design description, e.g., said Verilog module, is not captured. For example, Siemens proffers a tool called Questa that is capable of determining the coverage of a design. Such a tool automatically traverses a design's state spaces and identifies unreachable areas. Thereby it becomes possible to identify and/or exclude a design and/or to identify whether or not and/or to which extent a design code is used, e.g., when verifying one or more properties. Another tool used for that purpose may be a verification engine, such as OneSpin, which is capable of returning information about which parts of the design are not yet covered by the testbench. This information may be used to create a new prompt for the LLM, which instructs it to generate one or more properties for the uncovered code. As a result, a testbench with sufficient and/or a desired coverage of the design is obtained.

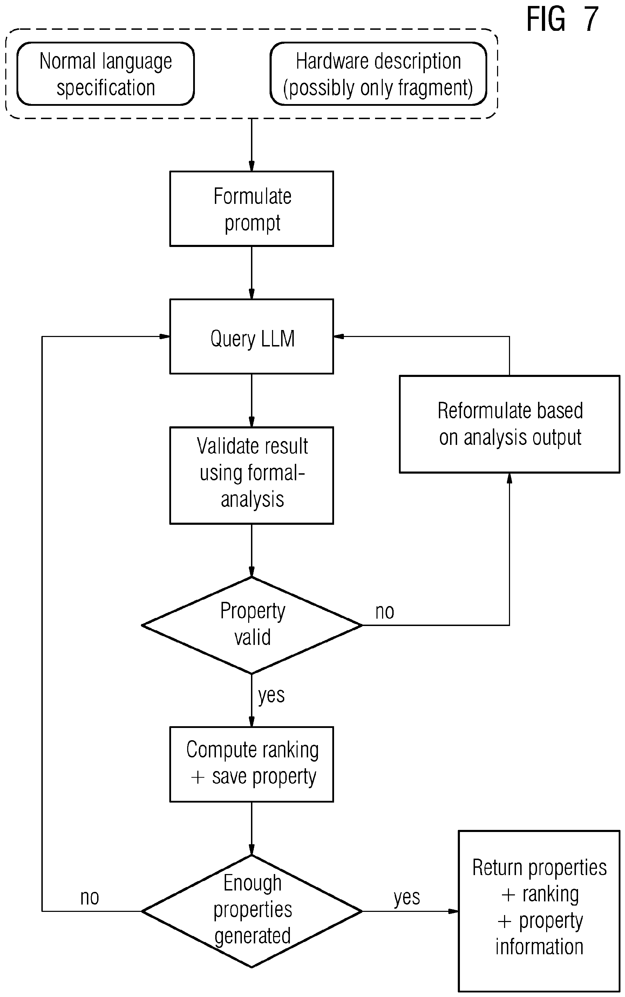

Turning to Figure 7, further details of an assertion generation loop are illustrated. A natural language specification of a design and/or a design in HDL, i.e. a hardware description (or possibly only a part or a fragment thereof), may be used for generating, i.e. formulating, a prompt. Alternatively, (solely) a design description, e.g. in a machine-readable format, such as HDL, may be input in an LLM, e.g. described in connection with Figure 6 and/or mode B. The prompt may be input in a LLM and may instruct or query the LLM to output one or more properties. For example, based on the prompt the LLM may output the one or more properties in HVL. A formal analysis tool, or a verification engine in general, may be used for checking the syntax and/or semantics of the one or more properties generated, e.g., comparing the properties with the design input. If the one or more properties are deemed valid the one or more properties may be saved, i.e. stored in a, preferably non-volatile, memory. If one or more properties are deemed invalid by the formal analysis tool the LLM may be queried again with additional information from the formal analysis tool. For example, additional information/data from the formal analysis tool may be added to the prompt. A new set of one or more properties may thus be generated based on the new prompt and the LLM may be queried again.

Now, if the one or more properties are deemed valid, e.g., by the formal analysis tool, the one or more properties may be stored, as mentioned. The one or more properties may be ranked, e.g. as also described herein. The properties may then be checked by a verification engine, e.g., in accordance with the ranking performed. Furthermore, it may be checked whether a sufficient amount of properties has been generated. In case not sufficient properties are available, the LLM may be queried again, or repeatedly in order to obtain further properties in the HVL. Finally, the properties may be stored, e.g., comprising information about the ranking of the properties and additional information relating to the properties, e.g. said coverage information.

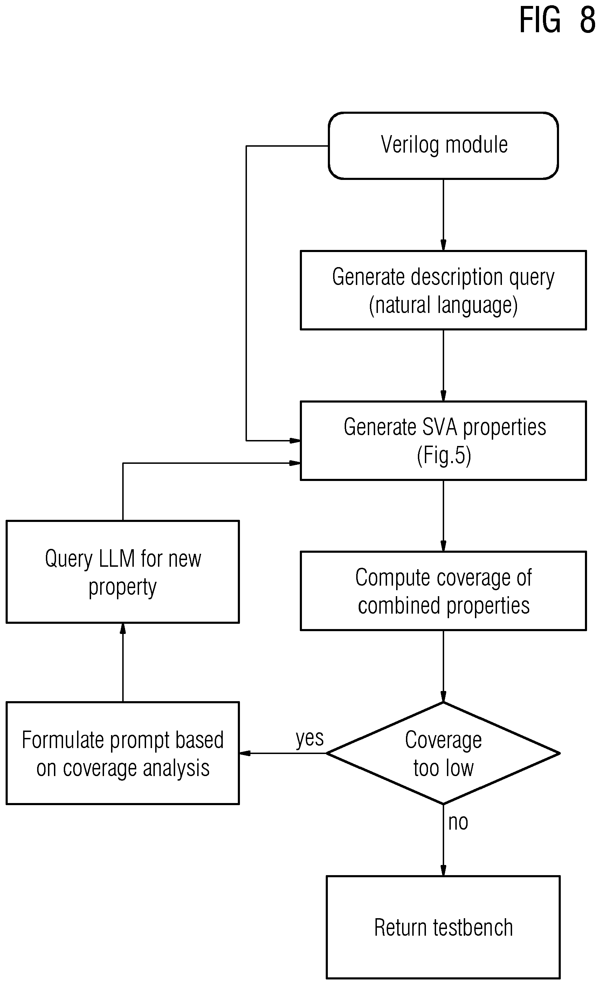

Turning to Figure 8, further details concerning the usage of coverage information are illustrated. As before, a design in HDL, such as a Verilog module, may be used to generate natural language expressions, i.e. prompting an LLM to generate a design description in natural language, i.e. said one or more natural language expressions, and to, e.g., subsequently, generate one or more properties in HVL, e.g., based on the one or more expressions. It needs to be mentioned again, that the reference to HDL is exemplary and that in general the design may be provided in a machine-readable form. Hence, HDL is used interchangeably with machine-readable form herein. Otherwise, the same description as in relation to in Figure 5 applies. It should be understood that the reference to HVL is exemplary and that in general a machine-readable property description can be used. Hence, HVL is used interchangeably with machine-readable property description herein.

In addition, the design description in a machine-readable form, such as HDL, may be used together with the one or more properties to compute a coverage of the one or more properties, i.e. the coverage of the combined properties, in the hardware code. In case the coverage is too low, i.e. below a predetermined threshold or does not cover one or more functions or a specific part of the design in HDL, a new prompt may be formulated based on the coverage analysis. Then, the LLM may be queried based on the prompt in order to generate new properties. The new properties may then be used again in connection with the design description in HDL in order to determine the coverage of the new set of properties. In case the coverage is deemed sufficient the set of properties may be returned or output, e.g., as part of a testbench. The properties may then be input into a verification engine, e.g., in order to check whether the one or more properties are satisfied.

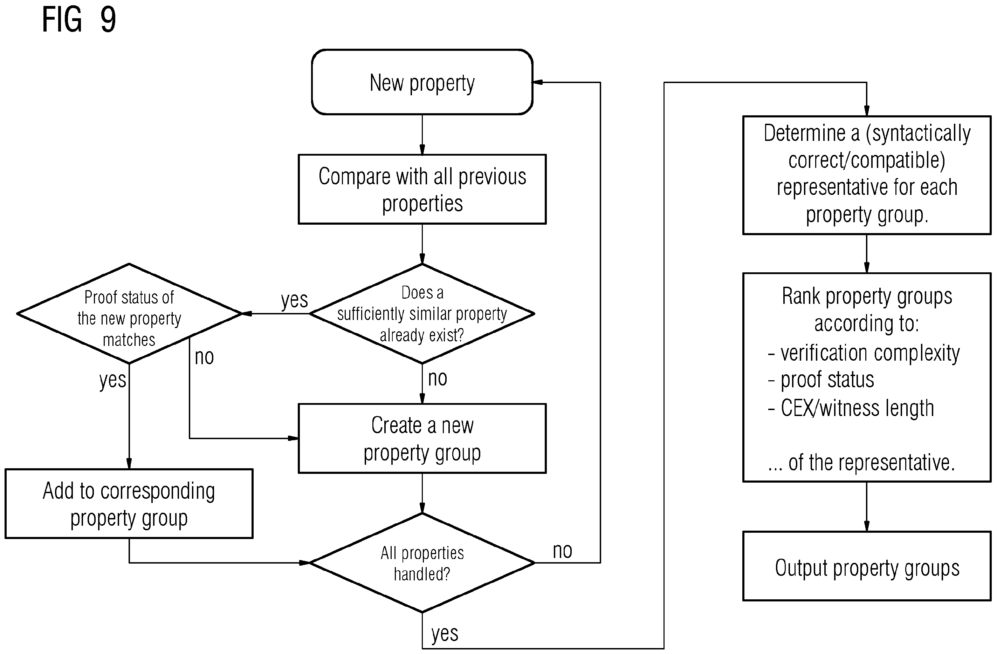

Now turning to Figure 9, further details relating to the ranking of the properties are illustrated. Starting with a property or new property a grouping and/or ranking of that property may be performed. The property may be selected from a plurality of properties, for example in the form of a list, and as, e.g., generated by an LLM, for example as described herein. To that end, the property may be compared with one or more or preferably all previously obtained properties, e.g., from said plurality of properties. The comparison may be based on a (string)similarity measure. Based on the comparison it may be determined whether the property is similar enough, e.g., based on a similarity threshold, to the already existing properties. If there is or are no other properties that are similar enough to the new property, a new property group may be created. If there are other properties similar enough to the new property it may be checked whether the proof status of the new property matches the proof status of the similar properties. To that end, a verification engine, such as a formal verification engine, i.e. a formal verification tool, also referred as formal analysis tool, may be used to check the whether the property is satisfied, i.e. holds true or not.

If the proof status of the new property matches the proof status of the one or more other properties in a group, the new property may be added to that group. If the proof status does not match the proof status of the other properties in the group, a new (property) group may be created. If all properties that have been generated, e.g., of a plurality of properties generated by the LLM, have been handled, i.e. a similarity check and/or a proof status check has been performed for each one of the plurality of properties, the grouping may be terminated and/or a representative property for each group may be determined. The representative property may be selected from the group or may itself be generated based on one or more of the properties in a group. The properties in a group and/or the groups themselves may be organize din the form of a list.

Subsequently the representative properties may be ranked, e.g., as described herein. Thereby not only a ranking of the representative properties but also of the corresponding groups may be obtained. The ranking may be performed in accordance with a verification complexity relating to the property, e.g., the representative property of a group or of any one or more of the properties in a group. Furthermore, the ranking may be performed in accordance with a proof status, e.g. a (representative) property that holds true may be ranked higher than a (representative) property that fails. Furthermore, the (representative) properties may be ranked in accordance with the length or number of counterexample, CEX, or based on whether a counterexample has been found. Still further the (representative) properties may be ranked in accordance with the presence of a witness or a length of the witness.

The resulting (representative) properties may then be output by a software component or software module which is used to implement the steps mentioned herein and/or stored in a, preferably non-volatile, memory. The software component may interface with the LLM, the verification engine and/or other software components for implementing the steps as described herein.

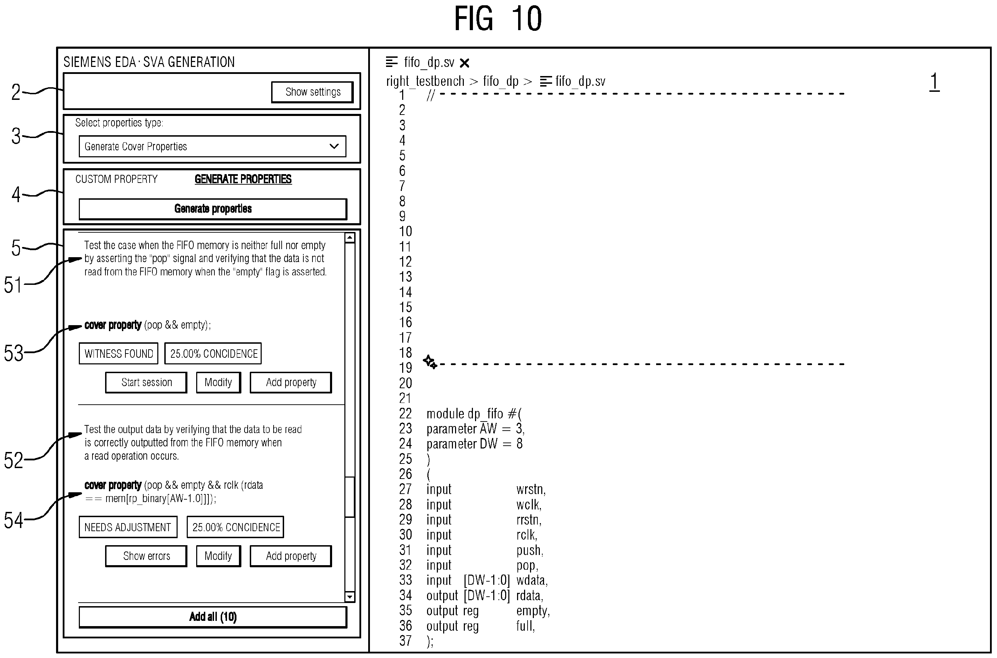

An interactive interface component is illustrated in Figure 10. The interactive interface component may serve for controlling the one or more software component and/or software modules as described herein. The interactive interface component may also serve for adding, inputting, editing, modifying, generating, and/or displaying, as shown in Figure 10, the natural language specification, the one or more natural language expressions, and/or the one or more properties. User experience, UX, is a critical factor when it comes to how effectively users can engage with a tool. To enhance the overall UX, it is essential to focus on improving the interface for displaying properties and/or assertions, in particular SVA instances and assessments, as well as enhancing the interaction with the verification engine, such as the System Verilog module. User such as Hardware designers usually rely on Integrated Development Environments, IDEs, to create their designs. Visual Studio Code, VSCode, stands out as one of the most widely used IDEs globally, which is based on web technologies. Thus, it is proposed to merge the use of LLMs to generate properties, e.g. SVA properties, with web technologies to display the results. It is intended to work with VSCode, but the visual aspect can be replicated in any other IDE (not necessarily with web technologies). For example, it much better than a command line interface as commonly used in the EDA toolsnowadays.

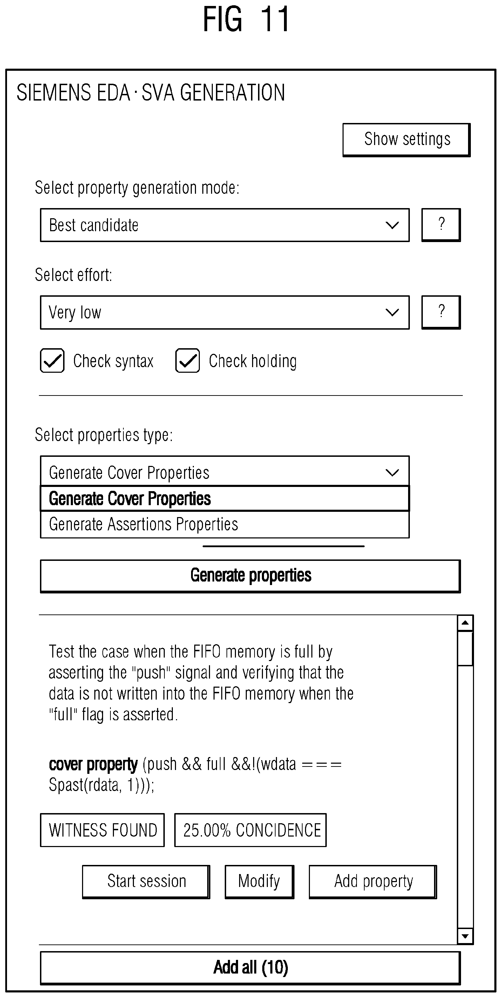

As shown in Fig. 10, the 1st section "1" shows how the user can write the design description in HDL through an editor and/or may add arbitrary parts of the design by adding more tabs and selecting parts of the code. This section "1" may serve as basis to define the part of the design description used in the techniques described herein. In section "2" a user can configure the behavior of software component and/or module. As also shown in Figure 11, a user may select between generate cover properties and generate assertion properties. In particular, an analysis-effort of the underlying, preferably formal, verification engine can be configured to only check syntax and/or to also verify the properties at hand ("Check holding"). The "effort" parameter lets the user adjust the number of repetitions or iterations that are run in the one or more (internal) feedback-loops, as described herein, e.g. in connection with the generation of a plurality of natural language expressions and/or plurality of properties, or the assertion generation loop or the testbench generation loop, as the case may be. A high number of repetitions or iterations may imply that the (formal) verification engine needs more time to produce an answer, but the answer will in general have a higher quality. The user can also configure the "property generation mode", which defines what properties are generated and/or presented. For example, the user might only be interested in properties that hold true in the model, that are syntactically correct, and/or a user may choose to only view the "best candidate" as computed by the ranking system.

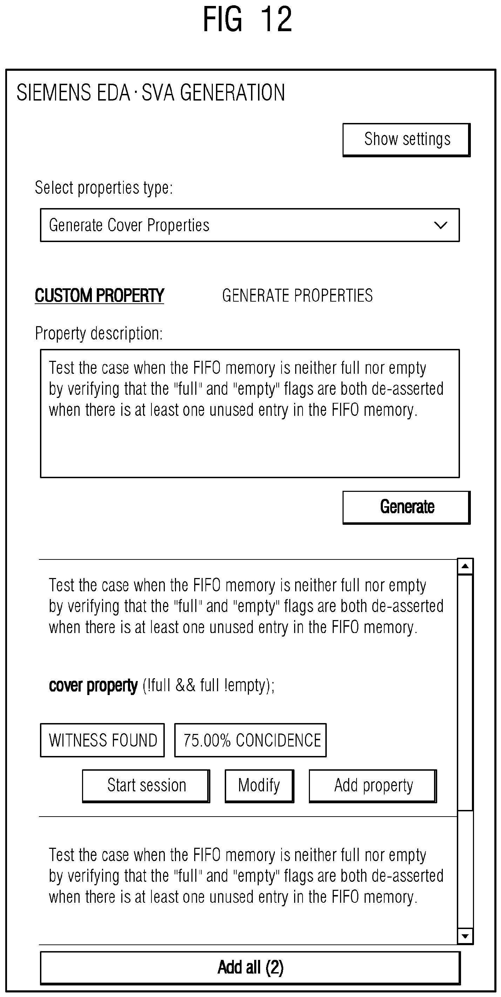

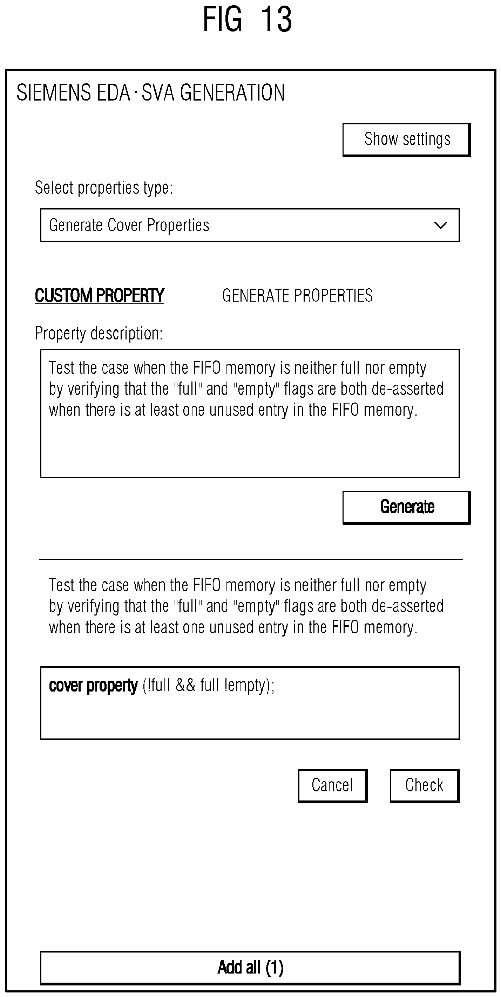

As shown in section "3" a user may choose the type of properties to be generated, e.g., said assertions to comprise one or more of the following: assert, cover, assume, and/or restrict. The effect of an assume statement is to instruct the verification engine to assume, without proof, that the given predicate is true. As show in in section "4" a user may select between the two modes, i.e. mode A and mode B, as described herein. In the case of one or more properties are generated, i.e. "generate properties", the user can trigger the "generate properties"-function to generate the one or more properties or a testbench, as described herein. In the case of the "custom assertion"-function, i.e., mode A, the user can add a custom description of the design in natural language through an input box, and by clicking the 'Generate' button, as e.g., shown in Figure 12, the list of properties in HVL or assertions will be displayed. In both cases the user can cancel these requests by clicking on 'CANCEL'. As shown in section "5" of Figure 10 the assertions are listed in rows, and at the end of the list the user can add all the assertions by clicking on 'ADD ALL ({NUMBER OF ASSERTIONS})'. Each row may comprise one or more of the following information:
1. an expression in natural language (corresponding a (representative) property in HVL).
2. a property in an HVL, e.g., in the form of an (SVA) assertion.
3. one or more tags describing the one or more properties, such as:
   a. HOLDS: The assertion property holds in the design.
   b. FAILS: The assertion property fails in the design.
   c. WITNESS FOUND: The cover property can be observed.
   d. UNREACHABLE: The cover property cannot be observed.
   e. NEEDS ADJUSTMENT: The syntax of the assertion is incorrect.
   f. COINCIDENCE: A heuristic that evaluates how much the assertion coincides with the assertion description.
   g. NO PROPERTIES FOUND: When no properties were obtained with the current "property generation mode" and "effort" configuration.
4. one or more buttons on a GUI to interact with the verification engine, e.g. in order to add, edit, and/or cancel one or more expressions, one or more properties, or verification engine settings, such as :
   a. ADD PROPERTY: Allows the user to integrate the property in a testbench / embedded in the module.
   b. SHOW ERRORS: In case the property is not syntactically correct or there was an error while assessing the property, this button will display the errors in the form of a notification.
   c. START SESSION: Also called DEBUG, allows the user to debug the property by opening a separate debugger tool.
   d. STOP SESSION: Finishes the started debug session. Also called END DEBUG.
   e. MODIFY: Also called EDIT allows the user to modify the result of the assertion check it through the formal verification tool, as, e.g., shown in Figure 13. This process is done by an input box with a button 'CHECK'. To cancel the process there is a button called 'CANCEL'.

Thus, a, preferably computer-implemented, method of property generation is proposed. The method can be implemented on a computer comprising a processor and a memory. Hence, an apparatus and/or system is proposed operative for performing one or more of the method steps. In particular the two-step approach of first letting the LLM generate a set of expression in natural language and to then have the LLM generate one or more properties in HVL significantly improves the usability of the properties. In particular, the repeated generation of properties for one (and the same) expression exploits the statistical nature of the LLM and allows identifying the most probable and correct properties to be used for the design. This leverages the LLMs ability to capture the intent of a given a piece of code describing the design. The actual generation of properties, such as SVA-specifications, can then be done on the reduced input of the one or more expressions, i.e. the property-descriptions in natural language. This greatly improves the results of the method.

Hence, multiple candidate properties for each expression, i.e., property-description, may be obtained. Furthermore, it is proposed to rank the properties according to a similarity-based algorithm, and/or to further attach attributes to one or more the properties based on a formal analysis, and/or allow the user to directly analyze corresponding traces, e.g. in a separate debugger window. The additional information, as provided partly by the formal analysis, makes it possible to quickly explore a range of candidate properties, i.e. assertions, and their behavior in the design. This is enabled by the inherent randomness in LLMs. By re-querying the LLM with the same, or similar, prompts we are able to propose many different natural language specifications and/or generated properties, e.g., (SVA) assertions, e.g., for the user to pick from. Furthermore, it is possible to generate a plurality of properties and thereby introduce a ranking and/or selection of the one or more properties.

The method may comprise a feedback-loop for property generation which involves a verification engine such as a formal verification engine or tool. Therein, one or more characteristics of the property can be assessed by the formal verification tool. These characteristics, e.g. comprising information about a proof state, a counterexample, a witness, or a coverage, can be used to generate new, and improved properties.

Hence, it is proposed to utilize the results of the formal analysis (tool) and to feed them back to the LLM, i.e. include the one or more results of the formal analysis in a new or amended prompt. For example, one or more errors in previous expressions or properties may be fed back to the LLM. This allows a guided interaction with the LLM and thereby improves the properties generated by the LLM.

Furthermore, a feedback-loop for generating testbenches is proposed. Said testbench may comprise, as mentioned herein, a plurality of expressions and/or a plurality of (corresponding) properties. The feedback-loop may be based on an, e.g., computed, coverage information, and may further comprise instructing the LLM to add one or more properties for one or more uncovered parts of the design.

Thus, diagnostics information or logging messages of a formal analysis tool may be (re-)used in queries to the LLM with the aim of explaining erroneous previously generated properties or with the aim of instructing the LLM to produce properties, or assertions, for uncovered code. Furthermore, the LLM may be instructed to generate a natural language specification summarizing the functional behavior of a given design, e.g., a hardware module.

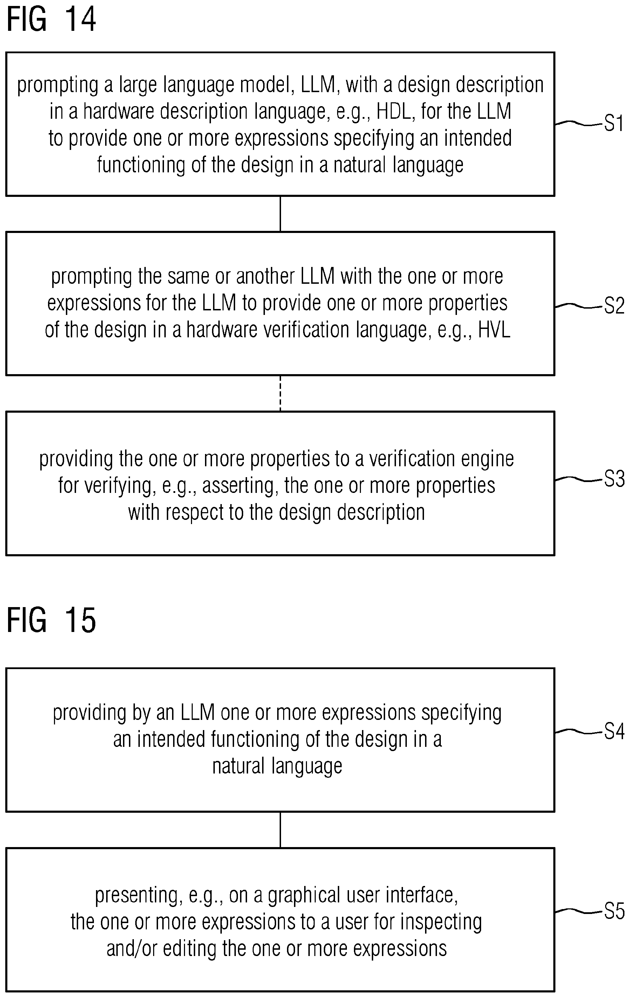

Further exemplary steps are illustrated in the Figures 14-XX.

A prompt is a (structured) instruction that can be interpreted and understood by a generative AI model, such as an LLM. A prompt may thus be understood an instruction, e.g., in natural language text, describing the task that an AI should perform.

A property may define a behavior of the design. A (named) property may be used for verification, e.g., as an assumption, an obligation, or a coverage specification. In order to use the behavior for verification, an assert, assume, or cover statement may be used. A property declaration by itself does not produce any result.

Hence, in a step S1 it is proposed to prompt a large language model, LLM, with a design description in a hardware description language, HDL, for the LLM to provide one or more expressions specifying an intended functioning of the design in a natural language.

To that end, generally available open source LLMs such as Llama or CodeLLama may be used These foundational models already provide sufficient accuracy for the desired task of generating accurate and valid properties. As a result, a natural language expression may be obtained, as, e.g., shown in Figure 10, section "5" for a design description of a FIFO memory the expression: "Test the case when the FIFO memory is empty by asserting the "pop" signal and verifying that the data is not read from the FIFO memory when "empty" flag is asserted" may be obtained.

In a second step the same or another LLM may be prompted with the one or more expressions for the LLM to provide one or more properties of the design in a hardware verification language, HVL. The prompt may for example comprise a template for structuring the properties, e.g.: Can you start by "assert property ("")"?. As also shown in Figure 10, section "5", the assertion "cover property (pop&& empty)" is obtained.

In a step S3 the one or more properties may be provided to a verification engine for verifying, e.g., asserting, the one or more properties with respect to the design description.

Hence, accurate and/or valid properties may be generated. In addition, the design or the design description may be modified based on information obtained from the verification engine. Thus, the effort for generating the correct properties may be reduced. Also, the number of iterations for generating a valid design description may be reduced. The one or more properties determined may be stored and reused for any similar design or for any amended design (description). Thus, based on the plurality of properties, as, e.g., filtered or ranked, an optimized testbench for verifying same or similar designs may be created.

It thus becomes possible to remove redundant properties and/or filtering out syntactically incorrect properties. Furthermore, the properties may be checked in an optimized order, e.g., according to the ranking performed. Thereby computing resources and computation time may be saved by addressing correct and non-redundant properties. Hence, the verification engine may be executed in the order to check the one or more properties in accordance with an optimal order. It is also possible to reuse one or more properties for the same or a similar design, e.g., the same properties should hold for a design with the same inputs and/or outputs of the design description in HDL, e.g. in Verilog.

Still further the design's one or more properties may be debugged without adding the properties to the testbench. This may also save computing resources because erroneous properties are not included in the testbench to begin with. Usually, one or more properties may be saved in testbench. The testbench may then be executed, i.e., the one or more properties of the testbench are checked by the verification engine, and eventually the property may not hold true., i.e. fail. Subsequently, the design description in HDL may be modified (for example by the user), i.e. since the property failed. Thereafter, the testbench may be used again in order to check whether the property now holds true with respect to the modified design description. Hence, a proper testbench with accurate and valid properties is of significant importance for the design of electronic circuits and in particular integrated circuits. As also already mentioned herein, the coverage may be improved by including feedback from a verification engine and generating one or more properties that address the uncovered code in the design (description). Thereby, the verification of the complete design is improved and the safety of the electronic circuit is improved.

As shown in Figure 15, in a step S4 an LLM may provide one or more expressions specifying an intended functioning of the design in a natural language. For example, the LLM may be prompted to summarize the functioning of the design description in a natural language.

In a step S5 the one or more expressions may be presented, e.g., on a graphical user interface, to a user for inspecting and/or editing the one or more expressions.

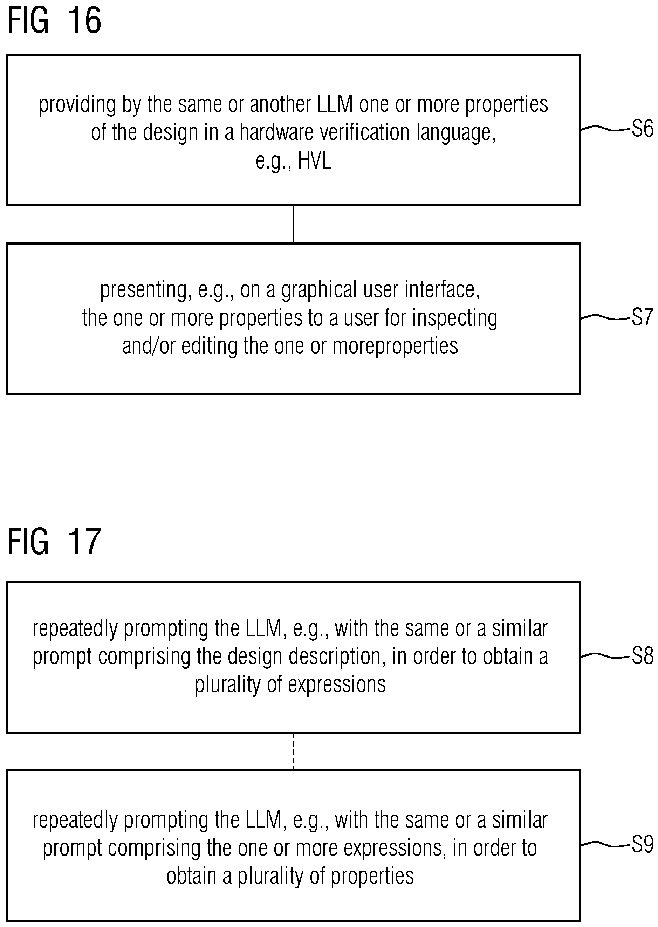

As shown in Figure 16, one or more properties of the design in a hardware verification language, HVL, may be provided by the same or another LLM (as the one used for the generation of the one or more natural language expressions) in a step S6. In a subsequent S7 the one or more properties may be displayed, i.e. presented, e.g., on a graphical user interface, to a user for inspecting and/or editing the one or more properties. Preferably the design description in HDL, the one or more properties and the one or more natural language expression are concurrently displayed to a user. This allows the used compare the different specifications and edit and change the respective specification where necessary.

As shown in Figure 17, in a step S8, the LLM, e.g., may be repeatedly prompted with the same or a similar prompt comprising the design description, in order to obtain a plurality of expressions. Similarly, the same or a different LLM may be repeatedly prompted, e.g., with the same or a similar prompt comprising the one or more expressions, in order to obtain a plurality of properties.

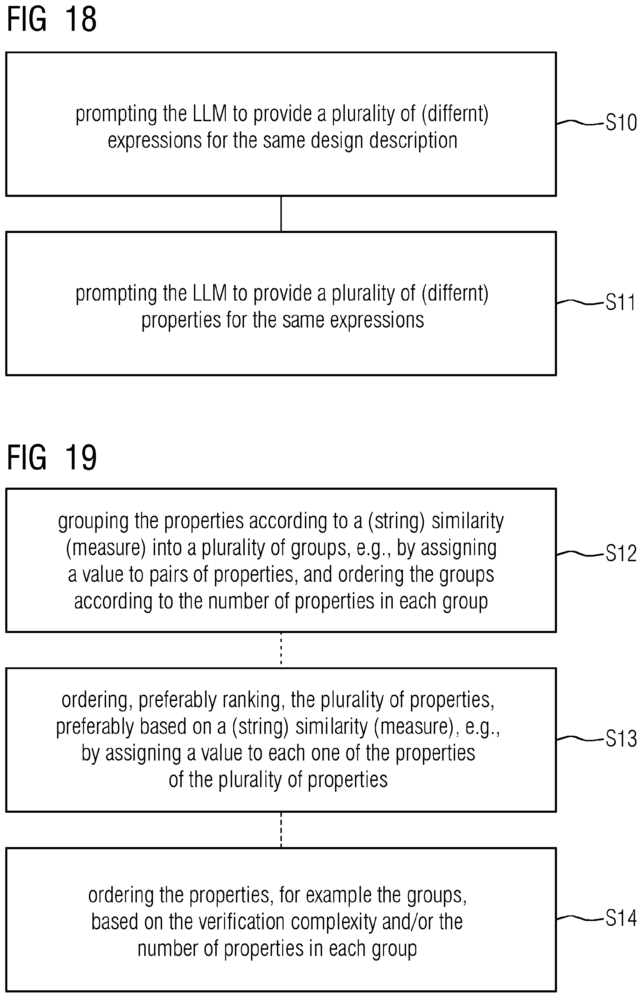

As shown in Figure 18, for example instead of repeatedly prompting the LLM, the LLM may be prompted to provide a plurality of (different) expressions for the same design description in a step S10. Similarly, the LLM may be prompted to provide a plurality of (different) properties for the same expressions. That is, a single prompt may be used to generate said plurality of expressions and/or properties.

As shown in Figure 19, in a step S12, the plurality of properties may be grouped according to a (string) similarity (measure) into a plurality of groups, e.g., by assigning a value to pairs of properties, and ordering the groups according to the number of properties in each group. As mentioned, thereby redundancy can be removed and at the same time the accuracy and/or validity of the properties can be determined. That is, the more properties are generated that are similar to each other the more likely a hallucination of the LLM can be excluded or the more likely the property is a correct property for the design.

In a step S13, the plurality of properties can be ordered, preferably ranked, preferably based on a (string) similarity (measure), e.g., by assigning a value to each one of the properties of the plurality of properties. Said ranking can thus be based on said similarity value. For example, properties exceeding a threshold may be grouped and also ordered. Thereby, the most numerous properties may be checked first by the verification engine.

Similarly, the properties, for example the groups, may be ordered based on the verification complexity and/or the number of properties in each group. Hence, a representative property of each group may be checked. For example, either the representative properties with the lowest verification time or with the longest verification time may be checked first.

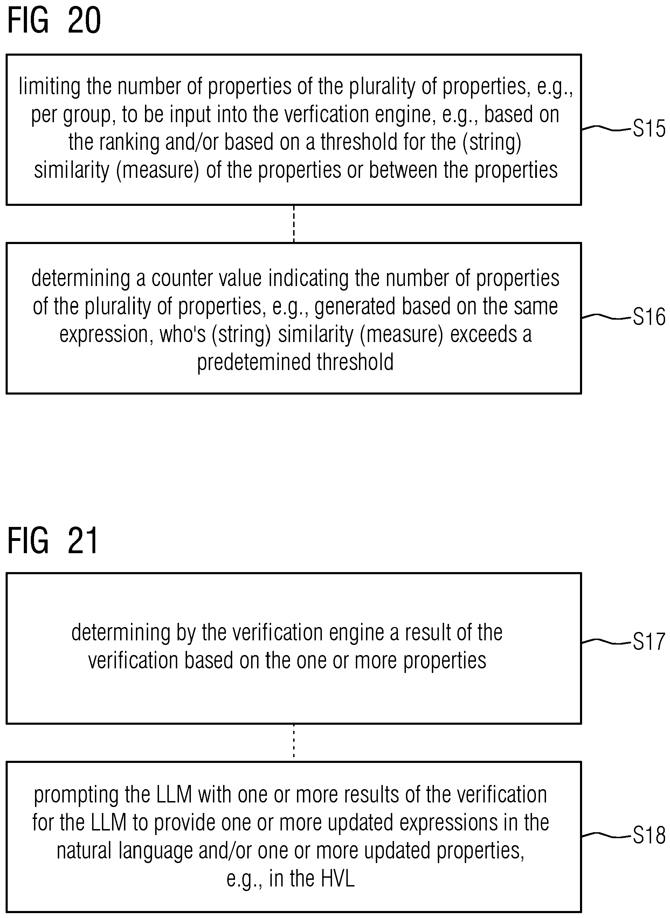

As shown in Figure 20, in a step S15, the number of properties of the plurality of properties, e.g., per group, to be input into the verification engine, may be limited, e.g., based on the ranking and/or based on a threshold for the (string) similarity (measure) of the properties or between the properties. In a step S16, a counter value indicating the number of properties of the plurality of properties may be determined, e.g., generated based on the same expression, who's (string) similarity (measure) exceeds a predetermined threshold.

As shown in Figure 21, in a step S17, a result of the verification based on the one or more properties may be determined by the verification engine. In a subsequent step S18, the LLM may be prompted with one or more results of the verification for the LLM. The LLM may thus provide one or more updated expressions in the natural language and/or one or more updated properties in the HVL.

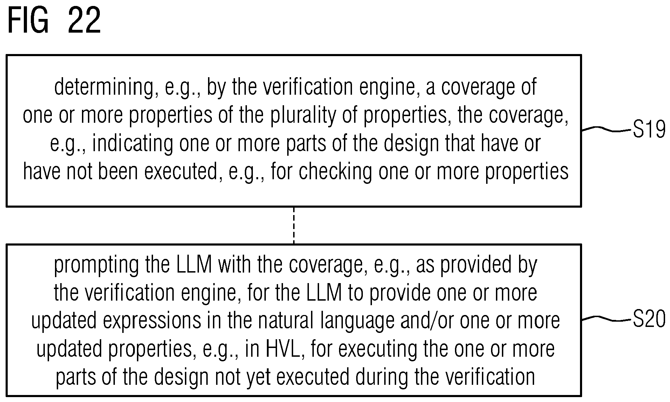

In Figure 22, in a step S19, a coverage of one or more properties of the plurality of properties, may be determined, e.g., by the verification engine. The coverage may indicate one or more parts of the design that have or have not been executed, e.g., for checking one or more properties. In a subsequent step S20, the LLM may be prompted with the coverage, e.g., as provided by the verification engine. The LLM may provide one or more updated expressions in the natural language and/or one or more updated properties in HVL for executing the one or more parts of the design not yet executed during the verification.

Further embodiments may comprise determining whether the one or more properties are syntactically correct, in the hardware verification language, HVL, and/or compatible with respect to the design description, e.g., matching one or more signal names in the design description, preferably before inputting the one or more properties into the verification engine. Further embodiments may comprise discarding one or more expression obtained from the LLM that cannot be parsed into one or more properties. Further embodiments may comprise prompting the LLM with a template to structure the one or more properties. Further embodiments may comprise checking, preferably by the verification engine, that the template has been respected.

## Claims

1. A, preferably computer-implemented, method of verifying a design of an electronic circuit (10), comprising the steps of:
prompting a large language model, LLM, (40) with a design description (30) in a machine-readable form, for example a hardware description language, HDL, for the LLM (40) to provide one or more expressions (51, 52) specifying an intended functioning of the design in a natural language,
prompting the same or another LLM (30) with the one or more expressions (51, 52) for the LLM (40) to provide one or more properties (53, 54) of the design in a machine-readable property description, for example a hardware verification language, HVL.

2. The method according to the preceding claim, further comprising providing the one or more properties (53, 54) to a verification engine for verifying, e.g., asserting, the one or more properties (53, 54) with respect to the design description.

3. The method according to any one of the preceding claims, further comprising presenting, e.g., on a graphical user interface, the one or more expressions (51, 52) to a user for inspecting and/or editing the one or more expressions, for example before determining the one or more properties (53, 54), and preferably concurrently displaying the one or more expressions (51, 52) and the one or more properties (53, 54).

4. The method according to any one of the preceding claims, further comprising the one or more expressions (51, 52) comprising a description of one or more functionalities of the design, for example without a description of the implementation of the functionalities within the design.

5. The method according to any one of the preceding claims, further comprising the properties (53, 54) specifying an intended functioning of the one or more functionalities independent of the implementation of the functionalities within the design.

6. The method according to any one of the preceding claims, further comprising repeatedly prompting the LLM (40), e.g., with the same or a similar prompt comprising the design description, in order to obtain a plurality of expressions, and/or
repeatedly prompting the LLM (40), e.g., with the same or a similar prompt comprising the one or more expressions, in order to obtain a plurality of properties.

7. The method according to any one of the preceding claims, further comprising prompting a second LLM (40) with the one or more expressions for the second LLM (40) to provide one or more paraphrased expressions specifying an intended functioning of the design in a natural language.

8. The method according to any one of the preceding claims, further comprising prompting the LLM (40) to provide a plurality of (different) expressions for the same design description, and/or
prompting the LLM (40) to provide a plurality of (different) properties for the same expressions.

9. The method according to any one the preceding claims, further comprising ordering, preferably ranking, the plurality of properties (53, 54), preferably based on a (string) similarity (measure), e.g., by assigning a value to each one of the properties (53, 54) of the plurality of properties.

10. The method according to any one of the preceding claims, further comprising grouping the properties (53, 54) according to a (string) similarity (measure) into a plurality of groups, e.g., by assigning a value to pairs of properties,
and ordering the groups according to the number of properties in each group.

11. The method according to any one of the preceding claims, further comprising determining a value of a verification complexity for one or more properties (53, 54), preferably for each group, e.g., based on a representative property from each group, wherein the verification complexity indicates an, e.g., heuristic estimate of an, amount of computations necessary for the verification engine to verify the property.

12. The method according to any one of the preceding claims, further comprising ordering the properties (53, 54), for example the groups, based on the verification complexity and/or the number of properties in each group.

13. The method according to any one of the preceding claims, further comprising limiting the number of properties (53, 54) of the plurality of properties, e.g., per group, to be input into the verification engine, e.g., based on the ranking and/or based on a threshold for the (string) similarity (measure) of the properties or between the properties.

14. The method according to any one of the preceding claims, further comprising determining a counter value indicating the number of properties of the plurality of properties, e.g., generated based on the same expression, who's (string) similarity (measure) exceeds a predetermined threshold.

15. The method according to any one of the preceding claims, further comprising determining by the verification engine a result of the verification based on the one or more properties,
the result indicating whether a property of the plurality of properties is satisfied or not, and/or indicating a length of a witness or counterexample to the property, and/or indicating a verification complexity value indicating an amount of computations necessary for the verification engine to verify the property.

16. The method according to any one of the preceding claims, further comprising prompting the LLM (40) with one or more results of the verification for the LLM (40) to provide one or more updated expressions in the natural language and/or one or more updated properties in the machine-readable property description, e.g., said HVL.

17. The method according to any one of the preceding claims, further comprising determining, e.g., by the verification engine, a coverage of one or more properties of the plurality of properties, the coverage, e.g., indicating one or more parts of the design that have or have not been executed, e.g., for checking one or more properties.

18. The method according to any one of the preceding claims, further comprising prompting the LLM (40) with the coverage, e.g., as provided by the verification engine, for the LLM (40) to provide one or more updated expressions in the natural language and/or one or more updated properties in the machine-readable property description, e.g., said HVL, for executing the one or more parts of the design not yet executed during the verification.

19. A computer program comprising program code that when executed performs the steps of any one of the previous claims.

20. An apparatus, preferably comprising a processor and a memory, operative to perform the steps of any one of the previous claims.
